# EUROPÄISCHE PATENTSCHRIFT

(11) **EP 1 775 412 B1**
(45) Veröffentlichungstag und Bekanntmachung des Hinweises auf die Patenterteilung: **15.04.2009**
(21) Anmeldenummer: 06122034.9
(22) Anmeldetag: 10.10.2006
(51) Int. Cl.: E06B 5/18, H05K 9/00, E06B 7/23

(54) **Tür oder Tor mit einer Dichtungseinrichtung zum Schutz gegen elektromagnetische Impulse**
Door or gate with a sealing arrangement for protection against electromagnetic pulse
Porte avec un dispositif d étanchéité pour protection contre une impulsion électromagnétique

(30) Priorität: 11.10.2005 DE 102005048700
(43) Veröffentlichungstag der Anmeldung: 18.04.2007
(73) Patentinhaber: Sommer Metallbau-Stahlbau GmbH & Co. KG, 95182 Döhlau (DE)
(72) Erfinder: Hautmann, Dieter, 95126 Schwarzenbach (DE); Hofmann, Jürgen, 92182 Tauperlitz (DE); Sommer, Oliver, 92028 Hof/Saale (DE)
(74) Vertreter: Skuhra, Udo

(56) Entgegenhaltungen:
- EP-A- 0 541 893
- US-A- 3 507 974
- US-A- 3 518 355
- US-A- 4 525 595
- US-A- 4 910 920

## Beschreibung

Die Erfindung betrifft eine Tür oder ein Tor mit einer zumindest teilweise umlaufenden Dichtung gemäß dem Oberbegriff des Patentanspruchs 1.

Verschiedene Gebäude, z.B. auch Krankenhäuser müssen vor elektromagnetischen Impulsen (EMP, Electromagnetic Pulse) geschützt werden, um Apparaturen gegenüber einer Beeinflussung von außen abzuschirmen.

Bei einem elektromagnetischem Impuls handelt es sich um eine sehr kurze, aber äußerst starke elektromagnetische Welle. Durch die induzierten Ströme in elektrisch leitfähigem Material können elektrische und elektronische Einrichtungen zerstört werden. Solche starken elektromagnetischen Impulse können beispielsweise durch Blitze oder Atombomben erzeugt werden.

Bei der Explosion einer Atombombe entsteht durch die Spalt- und Zerfallprozesse Gammastrahlung. Die Gammastrahlung wirkt auf die sie umgebenden Moleküle und Atome durch den Comptoneffekt. Durch den Comptoneffekt freigesetzte Elektronen bewegen sich mit hoher Geschwindigkeit vom Zentrum der Explosion weg, während sich die ionisierten Atome nur langsam bewegen können. Durch diese Ladungstrennung wird kurzzeitig ein starkes elektromagnetisches Feld aufgebaut. Dieses bricht schnell wieder in sich zusammen, da sich die positiv geladenen Ionen und Elektronen im Feld wieder aufeinander zu bewegen.

Das starke elektromagnetische Feld existiert zwar nur sehr kurz, die Auswirkungen können aber gravierend sein. Gerade weil das Feld derart schnell wieder in sich zusammenfällt, können hohe Spannungen in elektrisch leitfähigen Materialien entstehen. Da sich die Felder mit Lichtgeschwindigkeit ausbreiten, ist auch keine Warnung möglicherweise betroffener Gebiete möglich. Die entstehenden Spannungen und Ströme zerstören elektrische Geräte wie Transformatoren, Telefonleitungen, Computer oder dergleichen, sofern sie nicht entsprechend abgeschirmt sind.

In Abhängigkeit von der Ursache oder der Stärke des erzeugten elektromagnetischen Impulses wird zwischen LEMP (Lightning Electromagnetic Impulse), HEMP (High Electromagnetic Impulse) und NEMP (Nuclear Electromagnetic Impulse) differenziert.

LEMP-Schutzmaßnahmen sind in DIN V V DI V 0185 Teil 4 und HEMP-Schutzmaßnahmen sind in DIN EN 61000-2-9 standardisiert.

Zum Schutz von Gebäuden oder Räumen gegen hochfrequente elektromagnetische Impulse werden die Gebäude mit einem elektrisch leitenden Gewebe versehen, das eine Maschenweite je nach den Anforderungen besitzt. Problematisch sind jedoch die Eingangsbereiche, d.h. die Tür- und Torbereiche, da diese bei geschlossener Tür bzw. geschlossenem Tor ebenfalls eine Abschirmung gegenüber elektromagnetischen Impulsen gewährleisten sollen.

Aus der US-A-3,518,355 ist eine Schiebetür mit einer umlaufenden Dichtung bekannt, mit einer Halteleiste aus Metall, innerhalb welcher die Dichtung angeordnet ist. Die Dichtung ist hierbei pneumatisch aktivierbar. Oberhalb bzw. seitlich der Dichtung befindet sich eine verstellbare Platte, welche durch Führungseinrichtungen gegenüber der Halteleiste verstellbar geführt ist.

Der Erfindung liegt daher die Aufgabe zugrunde, eine Tür bzw. ein Tor zu schaffen, welches gegenüber einer Gebäudeöffnung einen sicheren Schutz gegenüber hochfrequenten elektromagnetischen Impulsen ermöglicht.

Diese Aufgabe wird erfindungsgemäß durch die im Patentanspruch 1 genannten Merkmale gelöst.

Weitere Ausgestaltungen der Erfindung ergeben sich aus den Unteransprüchen.

Die nachfolgend in Bezug auf eine Tür bzw. ein Tor beschriebene Anordnung lässt sich im Prinzip bei Drehtüren, Schiebetoren und Drehtoren einsetzen. Erfindungsgemäß ist eine Abschirmung gegenüber hochfrequenten elektromagnetischen Impulsen dadurch sichergestellt, dass im Bereich einer pneumatisch wirksamen Dichtung Federelemente vorgesehen sind, die zum Einen elektrisch gut leitend mit der Tür- bzw. Torplatte verbunden sind und zum Anderen aufgrund der Wirkung der pneumatischen Dichtung bei geschlossener Tür bzw. bei geschlossenem Tor gegen den gebäudeseitig angebrachten, elektrisch leitenden Einbaurahmen gedrückt werden.

Im Folgenden werden bevorzugte Ausführungsformen des erfindungsgemäßen Tores anhand der Zeichnung zur Erläuterung weiterer Merkmale beschrieben. Es zeigen:
Fig. 1 eine schematische Darstellung einer bekannten Anordnung mit elektrisch leitenden Kontaktfedern,
Fig. 2 eine schematische Darstellung eines Tores gegenüber einer Gebäudeöffnung gemäß der Erfindung,
Fig. 3 eine Teildarstellung eines Tores mit pneumatischer Dichtung und elektrischen Kontaktelementen, und
Fig. 4 eine schematische Perspektivansicht der Kontaktfederanordnung.

Nachfolgend wird eine bevorzugte Ausführungsform eines erfindungsgemäßen Tores mit pneumatischer Dichtung mit integrierter Abschirmung gegenüber elektromagnetischer Strahlung beschrieben, wobei vorzugsweise eine Abschirmung im Bereich von 3 MHz bis 3 GHz erwünscht ist.

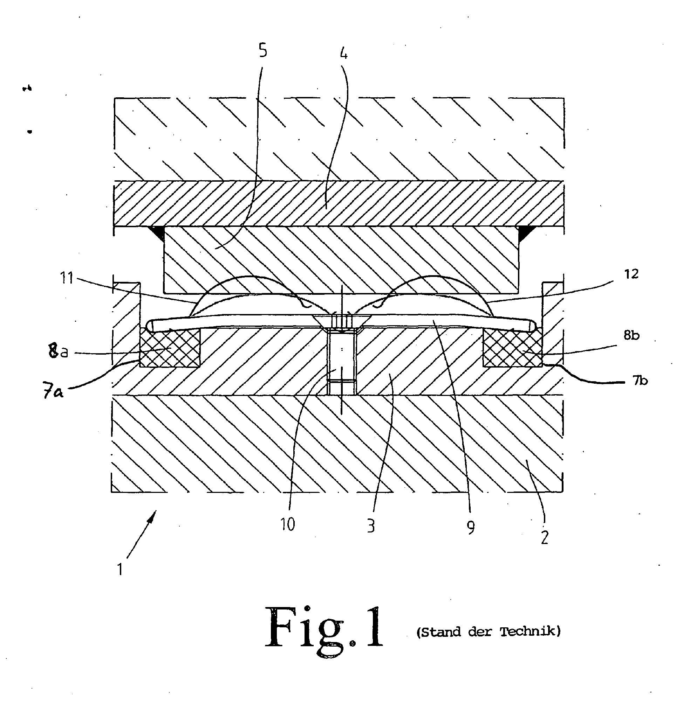

Fig. 1 zeigt eine an sich bekannte Anordnung an einem Drehtor zur Abschirmung gegenüber elektromagnetischen Impulsen. Die in Fig. 1 gezeigte Anordnung ist umlaufend an einem Drehtor vorgesehen und zur Anlage an einem gebäudeseitig eingesetzten Einbaurahmen aus Metall bzw. Stahl vorgesehen. Nach der bekannten Anordnung ist an dem mit 1 bezeichneten Tor auf der zur Gebäudeöffnung weisenden Seite eine Torkonstruktion 2 mit einer Platte oder Leiste 3 vorgesehen, die nahe den Seitenkanten des Tores vorzugsweise vollständig umlaufend ausgebildet ist und am Tor 1 an derjenigen Position angebracht ist, die im geschlossenen Zustand des Tores dem gebäudeseitigen Einbaurahmen 4 gegenüberliegt.

Am Einbaurahmen 4 ist eine entsprechende horizontal und/oder vertikal verlaufende Anschlagleiste 5 angebracht. Hierbei sind in der Leiste 3 zwei zueinander parallele Kanäle 7a, 7b vorgesehen. In diesen Kanälen oder Nuten 7a, 7b befinden sich elektrisch leitfähige Gewebestricke 8a, 8b, die mittels einer vorgespannten Feder 9 elektrisch kontaktiert werden, wobei die Feder 9 durch Schrauben 10 oder dergleichen an der Leiste 3 befestigt ist. Die Feder 9 kann in Form einer Federleiste vorgesehen sein, die sich über die gesamte Länge des Tores erstreckt. Durch die Schraubmittel 10 werden eine oder mehrere Kontaktfedern 11, 12 gegenüber der Leiste 3 fixiert und bewirken bei geschlossenem Tor einen elektrischen Kontakt zwischen der Leiste 3 einerseits und der Leiste 5 gebäudeseitig andererseits. Mit dieser Anordnung kann zwar eine elektrische Abschirmung der Gebäudeöffnung über das Tor erreicht werden. Es wird jedoch kein luftdichter Verschluss zwischen Tor und gebäudeseitigem Einbaurahmen hergestellt.

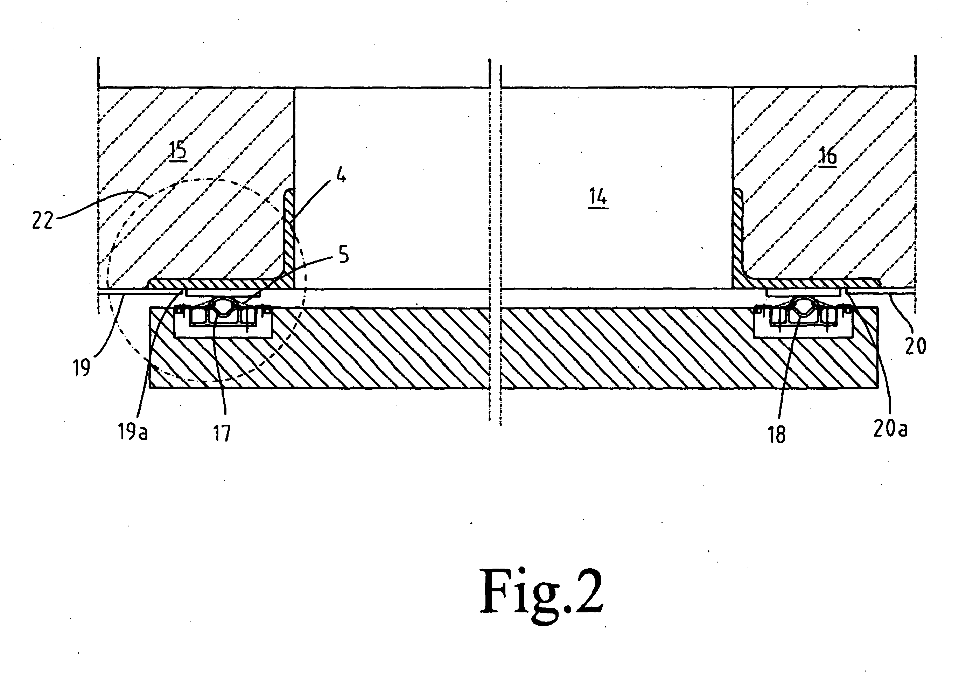

Fig. 2 zeigt eine schematische Anordnung zur Darstellung eines Tores mit pneumatischer Dichtung gegenüber einer Gebäudeöffnung 14. Die seitlich der Gebäudeöffnung 14 dargestellten Gebäudewandungen sind mit 15 und 16 bezeichnet. Aus Fig. 2 ist ersichtlich, dass das Tor 1 dem auf beiden Seiten der Gebäudeöffnung 14 angeordneten Einbaurahmen 4 zugeordnete pneumatische Dichtungen 17, 18 aufweist. Diese Dichtungen 17, 18 können horizontal an der oberen und unteren Seite des Tores vorgesehen sein bei entsprechendem Einbaurahmen in der Gebäudeöffnung, d.h., wenn die Einbaurahmen der Gebäudeöffnung 14 zusätzlich zu den vertikalen Abschnitten oben und unten horizontal verlaufend ausgebildet sind. Ersichtlicherweise wird eine vollständig umlaufende pneumatische Dichtung 17, 18 im Torbereich bevorzugt.

Wie sich aus Fig. 2 weiter ergibt, ist die Gebäudeaußenfläche mit einem elektrisch leitfähigen Gewebe 19, 20 ausgerüstet, welches über ein beispielsweise querstehendes Ende 19a, 20a mit den gebäudeseitigen Einbaurahmen in Berührung bzw. elektrischem Kontakt steht.

Nachfolgend werden Einzelheiten des in Fig. 2 mit 22 bezeichneten Bereichs näher erläutert.

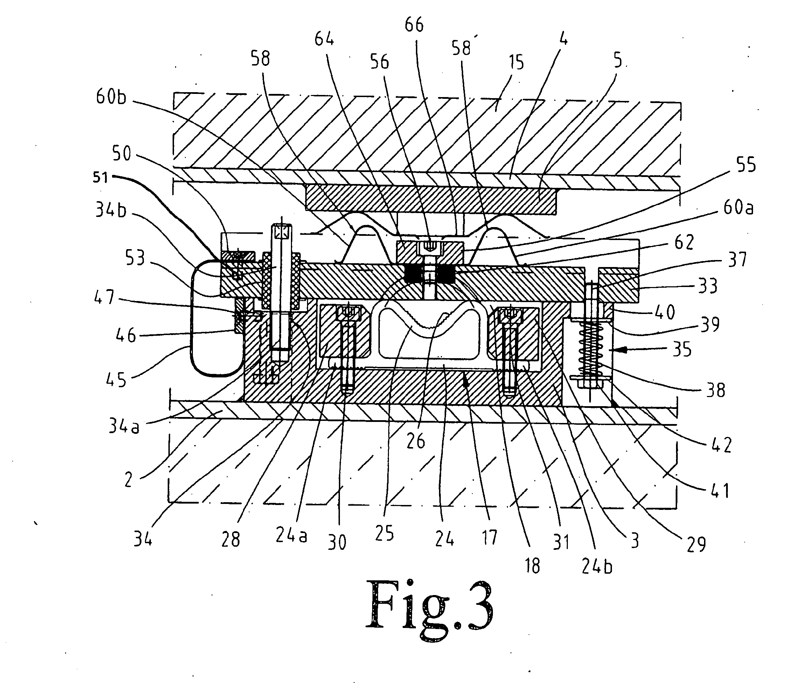

Fig. 3 zeigt eine bevorzugte Ausführungsform, die vorteilhafterweise bei einem Schiebetor Anwendung finden kann. Nach Fig. 3 weist das erfindungsgemäße Tor eine vorgesetzte Torkonstruktion 2 auf, an welcher eine Leiste, Schiene oder Platte 3 angebracht, vorzugsweise angeschweißt ist. Wie sich aus Fig. 2 ergibt, soll eine mit 17 bezeichnete Dichtung vorzugsweise an vier Seiten umlaufend an der Torinnenfläche angeordnet sein.

Nach Fig. 3 weist die Leiste 3 eine im Wesentlichen U-förmige Nut 18 auf, in welcher die im Wesentlichen schlauchförmige Dichtung 17 sitzt. Die Dichtung 17 weist eine Basis 24 auf, die mit sich seitlich abstrebenden Schenkeln 24a, 24b versehen ist, welche dazu dienen, die Dichtung 17 gegenüber der Leiste 3 zu fixieren.

Die Dichtung 17 weist eine verstellbare Fläche 25 auf, d.h. einen expandierbaren Abschnitt 25, der an seiner oberen Fläche mit Rippen, Rillen 26 oder dergleichen versehen ist.

Die Dichtung 17 ist im Bereich der quer zur Dichtungsachse verlaufenden Schenkel 24a, 24b mittels Klemmleisten 28, 29 und durch die Klemmleisten 28, 29 hindurchgehenden Schraubmitteln 30, 31 gegenüber der Leiste bzw. Schiene 3 gesichert. Die Schraubmittel 30, 31 werden in entsprechende Gewindebohrungen in der Leiste 3 eingeschraubt und klemmen damit die Schenkel 24a, 24b gegenüber der Leiste 3 fest.

In Fig. 3 ist die Dichtung 17 einmal im nicht-aufgeblähten Zustand und desweiteren im aufgeblähten Zustand dargestellt. Ersichtlicherweise verläuft die Nut 18 vorzugsweise vierseitig umlaufend an der zur Gebäudeseite weisenden Fläche des Tores. Die Höhe der Nut 18 und die Höhe der Dichtung 17 sind aufeinander abgestimmt. Die Klemmleisten 28, 29 befinden sich innerhalb der Nut 18, wie Fig. 3 zeigt.

An der Oberseite der Dichtung 17 befindet sich eine Platte 33, die durch Linearkugellager 34 auf der einen Seite der Dichtung 17 gelagert ist und durch eine oder mehrere Druckfedereinheiten 35 auf der anderen Seite. Ein vorzugsweise zylindrisches Teil 34a des Linearkugellagers sitzt fest in der Leiste 3, während das zugehörige ebenfalls vorzugsweise zylindrische Gegenstück 34b in Form einer Hülse in der Platte 33 fest angeordnet ist. Zur Unterstützung der Bewegung der Platte 33 dient die Druckfedereinheit 35, die aus einem fest in der Platte 33 verankerten Führungsstift 37 und einer Feder 38 besteht, die mittels einer Scheibe 39 oder dergleichen gegen einen Absatz 40 der Leiste 3 abgestützt ist. Das andere Ende der Feder 38 ist in bekannter Weise durch eine Mutter 41 mit Zwischenscheibe 42 gegenüber dem unteren Ende des Führungsstiftes 37 gesichert. Die Druckfedereinheit 35 verfolgt damit den Zweck, die Platte 33 in eine Position vorzuspannen, in welcher die Platte 33 auf der Oberfläche der etwa U-förmigen Leiste 3 aufliegt. Auf der zur Druckfedereinheit 35 gegenüberliegenden Seite nahe der Linearkugellagereinheiten 34 ist ein elektrisch leitfähiges Gewebeband 45 vorgesehen, welches mit seinem einem Ende beispielsweise an der Seite der Leiste 3 mittels einer Klemmleiste 46 und entsprechenden Schraubmitteln 47 oder dergleichen fixiert ist. Das andere Ende des Gewebebandes 45 ist in ähnlicher Weise an der Platte 3 durch eine Klemmleiste 50 und Schraubmittel 51 angebracht. Wesentlich ist, dass zwischen dem Gewebeband 45 und der Leiste 3 einerseits und dem Gewebeband 45 und der Platte 33 andererseits ein guter elektrischer Kontakt besteht. Bei der in Fig. 3 dargestellten Ausführungsform ist die Klemmleiste 46 seitlich an der Leiste 3 befestigt, während das Gewebeband 45 an der oberen Fläche der Platte 33 mittels der Leiste 50 nahe der Außenkante der Platte 33 angebracht ist. Bei der in Fig. 3 gezeigten Ausführungsform ist weiterhin der Kugellagerabschnitt 34b mit einer Hülse aus nicht-metallischem Material umgeben, die mit 53 bezeichnet ist und die in eine entsprechende Bohrung der Platte 33 zusammen mit dem Abschnitt 34 eingesetzt ist.

An der Oberseite der Platte 33 befindet sich wiederum eine Klemmleiste 55, die durch Schraubmittel 56 an der oberen Fläche, beispielsweise mittig der Platte 33 angebracht ist und zur Halterung von Kontaktfedern 58, 58' dient. Die Kontaktfedern 58, 58' haben hierbei vorzugsweise eine solche Form, dass deren Endabschnitte etwa V-förmig gebildet sind, während das Ende in Fig. 3 nach Art eines Hakens bzw. als auslaufendes, geschwungenes Ende gebildet ist, derart, dass das hakenförmige Ende 60a im Falle eines Kontaktes mit der Anschlagleiste 5 in Fig. 3 leitend nach der Seite verlagert werden kann. Gleiches gilt für das linke Federende 60b, welches im Falle eines Kontaktes der Feder mit der Anschlagleiste 5 in Fig. 3 nach links verlagert wird. Wesentlich ist somit, dass die beiden Federenden gegenüber der Anschlagleiste 5 bzw. gegenüber der Platte 3 verstellbar sind, wenn die Dichtung 17 aufgeblasen wird und damit die Kontaktfedern 58, 58' in Richtung auf die Anschlagleiste 5 gedrückt werden.

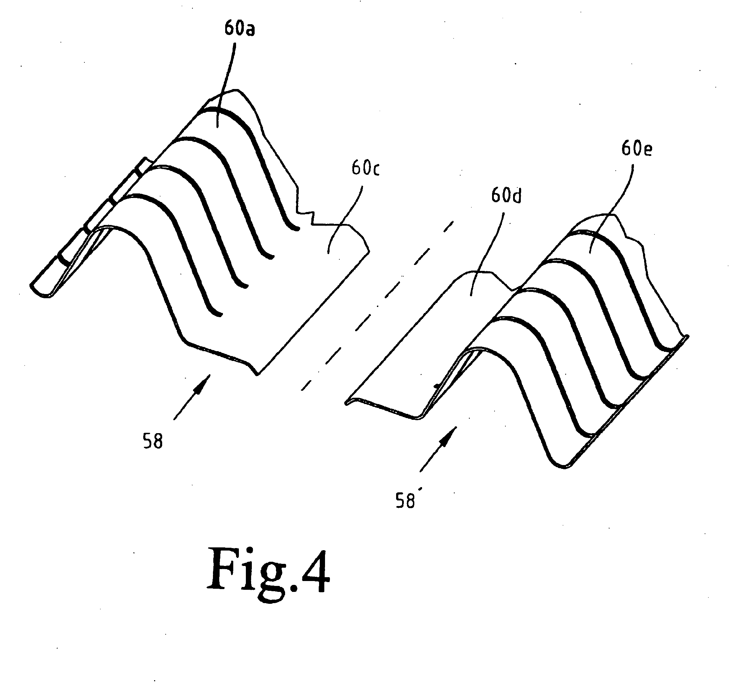

In Fig. 3 und 4 sind als Kontaktfedern 58, 58' zwei Kontaktfederelemente dargestellt, die spiegelsymmetrisch zueinander angeordnet sind. Die mit 60c, 60d bezeichnete seitenförmige Basis wird durch die Klemmleiste 55 eingespannt. Bei einer Ausführungsform können die Basis 60c, 60d überlappend bzw. übereinanderliegend vorgesehen sein. Bei einer weiteren Ausführungsform wird anstelle eines Kontaktfederpaares 58, 58' einen einzige, vorzugsweise spiegelsymmetrisch geformte Kontaktfeder verwendet.

Die Funktionsweise der Tordichtung ist wie folgt:

Wenn die Dichtung 17 unter Druck gesetzt ist, der bei 0,1 bis 0,5 bar liegen kann, wird durch die Linearkugeleinheiten 34 als Führung auf der einen Seite und die Druckfedereinrichtungen 35, die gleichzeitig als Führungen auf der anderen Seite wirken, eine Verstellung der Platte 33 in Fig. 3 nach oben bewirkt, wenn das Schiebetor seine geschlossene Stellung eingenommen hat und demzufolge die Druckwirkung der Dichtung 17 zur Verlagerung der Platte 33 ausgenutzt wird. Durch die Verstellung der Platte 33 in Fig. 3 nach oben, d.h. in Richtung der Gebäudeöffnung werden die Kontaktfedern 58 in Richtung auf die Anschlagleiste 5 gedrückt und bewirken damit einen elektrischen Kontakt zwischen der Platte 33 einerseits und der Anschlagleiste 5 des Einbaurahmens 4 andererseits. Da die Anschlagleiste 5 fest mit dem Einbaurahmen 4 verbunden, beispielsweise verschweißt ist, besteht zwischen beiden Teilen ein direkter elektrischer Kontakt. Das Gewebeband 45 dient hierbei ebenfalls als elektrischer Leiter zur Herstellung eines elektrischen Kontaktes zwischen der Platte 33 einerseits und der Leiste 3 bzw. der verbleibenden Torkonstruktion 2 andererseits.

Auf diese Weise wird gewährleistet, dass die Gebäudeöffnung mittels der beschriebenen Dichtungskonstruktion mit Gewebeband 5 elektrisch überbrückt wird gegenüber der an der Gebäudeaußenwandung befindlichen elektrisch leitfähigen Gewebeschicht 19 (Fig.2).

Wenn der Luftdruck der Dichtung 17 aufgehoben wird, stellt sich bei der beschriebenen Anordnung die Platte 33 aufgrund der Wirkung der Druckfeder 35 in Richtung auf die Leiste 3 zurück, d.h. in Richtung auf die Torkonstruktion 2, wodurch der Kontakt zwischen Platte 33 bzw. Leiste 3 und Anschlagleiste 5 freigegeben wird und die Toröffnung vorgenommen werden kann.

Um einen guten elektrischen Kontakt zwischen den Kontaktfedern 58, 58' und der Platte 33 zu gewährleisten, ist die Platte 33 in dem Auflagebereich 62 der Klemmleiste 55 nutförmig ausgespart zur Aufnahme eines elektrisch leitfähigen Gewebes, auf welches oder in welches die Kontaktfedern 58, 58' hineinreichen können. Durch die Klemmleisten 55 wird jedenfalls ein guter elektrischer Kontakt zwischen der Platte 33 und in die Nut 62 eingelegten Gewebestricken bzw.
Gewebeleisten 64 hervorgerufen.

Falls ein luftdichter Verschluss gewünscht ist, kann die Anschlagleiste 55 mit einer Dichtung 66 versehen sein, die in Fig. 3 strichliert angedeutet ist, wobei die Dichtung 66 durch nach oben gerichtete Rippen oder Rillen gebildet sein kann und im Falle einer Druckbeaufschlagung der Dichtung 17 fest gegen die Anschlagleiste 5 drückt.

Die in Fig. 3 gezeigte Anordnung ist, wie vorstehend beschrieben, über die vier Seiten umlaufend am Tor an der zur Gebäudefläche weisenden Seite des Tores vorgesehen, wie dies durch Fig. 2 angedeutet ist.

Durch die erfindungsgemäße Anordnung einer Dichtung 17 zur Verlagerung der Platte 33 in Richtung auf die Anschlagleiste 5 in Verbindung mit den Kontaktfedern 58 und gegebenenfalls flexiblen Dichtungen 66 aus Gummi oder dergleichen lässt sich nicht nur eine elektrische Überbrückung von Gebäudeöffnungen, sondern auch ein luftdichtes Verschließen von Gebäudeöffnung gewährleisten.

Bei der in Fig. 3 dargestellten Ausführungsform werden als Dichtung 17 und/oder Dichtung 66 vorzugsweise solche aus Gummi oder anderem flexiblem Material verwendet. Die in die Nut 62 eingesetzten Gewebestreifen oder Gewebestricke 64 bestehen vorzugsweise aus einem Kupfermaterial mit hoher elektrischer Leitfähigkeit. Die Federn 58, 58' sind in ihren Endabschnitten 60a, 60b quer zur Achse der Dichtung 17 vorzugsweise geschlitzt (Fig. 4), während sie im Bereich der Klemmleiste 55 durchgängig in Form von durchgängigen Streifen ausgebildet sind oder ausgebildet sein können. Ersichtlicherweise sind die Kontaktfedern 58, 58' ebenfalls umlaufend analog zu den Dichtungen 17 an der Türkonstruktion 2 vorgesehen. Bei Toren bzw. Schiebetoren der in Fig. 3 dargestellten Art handelt es sich um solche Tore, die gewichtsmäßig im Bereich 150 und 400 t liegen, entsprechend ist der Druck der Dichtungen 17 zu wählen, um einen festen Kontakt zwischen dem Tor selbst einerseits und dem Einbaurahmen 4 andererseits zu gewährleisten.

Als Gewebe bzw. Gewebestricke 64 bleiben vorzugsweise EMV-Dichtungen in Form von Gewebestricken mit Abmessungen von 10 x 10 mm benutzt. Die Kontaktfedern 58, 58' bestehen vorzugsweise aus CuBr.

Die Kontaktfedern 58, 58' sind vorzugsweise derart ausgebildet, dass sie entlang des Klemmbereichs der zwischen der Platte 33 und der Klemmleiste 55 liegen und durchgängig, d.h. nicht unterbrochen ausgebildet sind, während die Enden 60a, 60b geschlitzt sind, derart, dass die Schlitzbreite vorzugsweise 1 mm beträgt. Die auf diese Weise gebildeten Federzungen, d.h. die Abschnitte zwischen den Schlitzen haben vorzugsweise eine Breite von 6 mm.

Die Gewebebänder 45 sind vorzugsweise nur auf einer Seite der Leisten 3 umlaufend vorgesehen, so dass eine elektrische Brücke zwischen den Rändern der Gebäudeöffnung über die Torkonstruktion 2 bzw. die Leisten 3 definiert ist.

Fig. 4 zeigt eine schematische Darstellung der Kontaktfederanordnung mit Federendbereichen 60a und 60b entsprechend der Darstellung nach Fig. 3. Wie sich aus Fig. 4 ergibt, sind nur die beidseitigen Enden der Kontaktfederanordnung geschlitzt. Die Schlitzbreite von 1 mm wird bevorzugt, wobei die Schlitzbreite abhängig vom jeweiligen Anwendungsfall ist, d.h. die Schlitzbreite wird auf die abzuschirmende Wellenlänge bzw. Impulslänge abgestimmt.

## Patentansprüche

1. Tor mit einer zumindest teilweise umlaufenden Dichtung (17),
mit einer Halteleiste (3) aus Metall, innerhalb welcher die Dichtung (17) angeordnet ist,
mit einem dem Tor zugeordneten gebäudeseitig vorgesehenen Einbaurahmen (4),
wobei die Dichtung (17) pneumatisch aktivierbar ist,
mit einer über der Dichtung (17) angeordneten verstellbaren Platte (33), die durch Führungseinrichtungen (34, 35) gegenüber der Halteleiste (3) verstellbar geführt ist, **dadurch gekennzeichnet dass**
die verstellbare Platte (33) auf der Halteleiste (3) aufliegt,
dass ein elektrisch leitender Gewebestreifen (45) vorgesehen ist, der die Halteleiste (3) elektrisch mit der Platte (33) verbindet,
und dass auf der Platte (33) Kontaktfedern (58, 58') angeordnet sind, die elektrisch leitfähig sind und in Anlage zu einer Anschlagleiste (5) des Einbaurahmens (4) verbringbar sind.

2. Tor nach Anspruch 1,
**dadurch gekennzeichnet, dass** die Dichtung (17) seitlich abstehende Schenkel (24a, 25b) aufweist, die mittels Klemmleisten (28, 29) und Schraubmitteln (30, 31) in bzw. an der Halteleiste (3) befestigt ist.

3. Tor nach Anspruch 2,
**dadurch gekennzeichnet, dass** die Halteleiste (3) eine im Wesentlichen U-förmige Ausnehmung (18) aufweist, innerhalb welcher die Dichtung (17) mit den Klemmleisten (28, 29) angeordnet ist.

4. Tor nach einem der vorangehenden Ansprüche,
**dadurch gekennzeichnet, dass** die Kontaktfedern (58, 58') durch zusätzliche Klemmleisten (55) an der Platte (33) befestigt sind.

5. Tor nach Anspruch 4,
**dadurch gekennzeichnet, dass** an der Oberseite der Platte (33) Nuten (62) zur Aufnahme eines elektrisch leitfähigen Gewebes (64) ausgebildet sind, wobei das Gewebe (64) in elektrischem Kontakt mit den Kontaktfedern (58, 58') steht.

6. Tor nach wenigstens einem der vorangehenden Ansprüche,
**dadurch gekennzeichnet, dass** die Kontaktfedern (58, 58') abgebogene Endabschnitte (60a, 60b) aufweisen.

7. Tor nach wenigstens einem der vorangehenden Ansprüche,
**dadurch gekennzeichnet, dass** die Kontaktfedern (58, 58') entlang einer gegenüber der Platte (33) befestigten Klemmleiste (55) durchgängig ausgebildet sind.

8. Tor nach Anspruch 7,
**dadurch gekennzeichnet, dass** die Kontaktfedern (58, 58') an ihren Enden (60a, 60b) geschlitzt sind.

9. Tor nach Anspruch 8,
**dadurch gekennzeichnet, dass** die Breite der Schlitze ca. 1 mm beträgt.

10. Tor nach Anspruch 4,
**dadurch gekennzeichnet, dass** auf den zusätzlichen Klemmleisten (55) eine flexible Dichtung (66) angebracht ist.

11. Tor nach einem der vorangehenden Ansprüche,
**dadurch gekennzeichnet, dass** der Gewebestreifen (45) wenigstens auf einer Seite der Leiste (3) umlaufend ausgebildet ist.

## Claims

1. A gate having one at least partial circumferential sealing (17), comprising:
a metal support rail (3) within which said sealing (17) is arranged,
a mounting frame (4) assigned to said gate and provided at a building,
wherein said sealing (17) can be pneumatically activated,
a movable plate (33) arranged above said sealing (17), said plate (33) being movable and guided by guiding means (34, 35) in relation to said support rail (3), **characterized in that**
said movable plate (33) is supported by said support rail (3),
an electrically conductive fabric strip (45) electrically connecting said support rail (3) to said plate (33) is provided, and
contact springs (58, 58') being electrically conductive are arranged on said plate (33), said contact springs (58, 58') being movable to bear against a stop bar (5) of said mounting frame (4).

2. The gate according to claim 1,
**characterized in that** said sealing (17) comprises laterally projecting legs (24a, 25b) being attached by clamp strips (28, 29) and screw means (30, 31) into or to said support rail (3).

3. The gate according to claim 2,
**characterized in that** said support rail (3) comprises an essentially U-shaped recess (18) within which said sealing (17) is arranged together with said clamp strips (28, 29).

4. The gate according to any one of the preceding claims,
**characterized in that** said contact springs (58, 58') are attached by additional clamp strips (55) to said plate (33).

5. The gate according to claim 4,
**characterized in that** grooves (62) for receiving an electrically conductive fabric (64) are formed in the top side of said plate (33), the fabric (64) being in electrical contact with said contact springs (58, 58').

6. The gate according to at least any one of the preceding claims,
**characterized in that** said contact springs (58, 58') comprise bent end portions (60a, 60b).

7. The gate according to at least one of the preceding claims,
**characterized in that** said contact springs (58, 58') are continuously formed along a clamp strip (55) fixed to said plate (33).

8. The gate according to claim 7,
**characterized in that** said contact springs (58, 58') comprise slotted ends (60a, 60b).

9. The gate according to claim 8,
**characterized in that** the width of said slots is about 1 mm.

10. The gate according to claim 4,
**characterized in that** a flexible sealing (66) is attached to said additional clamp strip (55).

11. The gate according to any one of the preceding claims,
**characterized in that** said fabric strip (45) is circumferentially formed on at least one side of said rail (3).

## Revendications

1. Porte avec un joint d'étanchéité (17) au moins en partie périphérique, comprenant:
un rail métallique (3) de fixation dans lequel ledit joint d'étanchéité (17) est arrangé un cadre de montage (4) assigné à ladite porte et prévu dans un bâtiment,
ledit joint d'étanchéité (17) étant activable pneumatiquement,
une plaque réglable (33) arrangée au-dessus dudit joint d'étanchéité (17), ladite plaque (33) étant réglable et étant guidée par moyens de guidage (34, 35) par rapport audit rail métallique (3) de fixation, **caractérisée en ce**
**que** ladite plaque réglable (33) repose sur ledit rail métallique (3) de fixation,
**qu'**un ruban en tissu (45) électroconducteur raccordant électriquement ledit rail métallique (3) de fixation à ladite plaque (33) est prévu, et
**que** des ressorts de contact (58, 58') électroconducteurs sont arrangés sur ladite plaque (33) et peuvent être mis en appui contre un rebord (5) dudit cadre de montage (4).

2. Porte selon la revendication 1,
**caractérisée en ce que** ledit joint d'étanchéité (17) comprend des pieds (24a, 25b) saillant latéralement et fixés par des bandes de serrage (28, 29) ou des raccordements à vis (30, 31) audit respectivement dans ledit rail métallique (3) de fixation.

3. Porte selon la revendication 2,
**caractérisée en ce que** ledit rail métallique (3) de fixation comprend un creux (18) essentiellement en forme d'U, dans lequel ledit joint d'étanchéité (17) est arrangé avec lesdits bandes de serrage (28, 29).

4. Porte selon l'une des revendications précédentes,
**caractérisée en ce que** lesdits ressorts de contact (58, 58') sont attachés par des bandes de serrage (55) supplémentaires à ladite plaque (33).

5. Porte selon la revendication 4,
**caractérisée en ce que** des rainures (62) sont formées dans la face supérieure de ladite plaque (33) pour un logement d'un ruban en tissu (64) électroconducteur, ledit ruban en tissu (64) étant en contact électrique avec lesdits ressorts de contact (58, 58').

6. Porte selon au moins l'une des revendications précédentes,
**caractérisée en ce que** lesdits ressorts de contact (58, 58') comprennent des sections d'extrémité (60a, 60b) pliées.

7. Porte selon au moins l'une des revendications précédentes,
**caractérisée en ce que** lesdits ressorts de contact (58, 58') sont formés continuement le long d'une bande de serrage (55) attachée à ladite plaque (33).

8. Porte selon la revendication 7,
**caractérisée en ce que** lesdits ressorts de contact (58, 58') comprennent des extrémités (60a, 60b) à fente.

9. Porte selon la revendication 8,
**caractérisée en ce que** la largeur desdits fentes se mente à environ 1 mm.

10. Porte selon la revendication 4,
**caractérisée en ce qu'**un joint d'étanchéité (66) flexible est attaché à ladite bande de serrage (55) supplémentaire.

11. Porte selon l'une des revendications précédentes,
**caractérisée en ce que** ledit ruban en tissu (45) est formé périphériquement sur au moins un côté dudit rail (3).
